# EUROPÄISCHE PATENTANMELDUNG

(11) **EP 1 778 002 A2**
(43) Veröffentlichungstag der Anmeldung: **25.04.2007**
(21) Anmeldenummer: 06120207.3
(22) Anmeldetag: 06.09.2006
(51) Int. Cl.: H05K 13/04

(54) **Zuführeinrichtung für elektrische Bauteile**

(30) Priorität: 28.09.2005 DE 102005046395
(71) Anmelder: SIEMENS AKTIENGESELLSCHAFT, 80333 München (DE)
(72) Erfinder: Lintner, Albert, 83714, Miesbach (DE); Nitsch, Andreas, 86875, Bronnen (DE)

(57) **Zusammenfassung**

Eine Zuführeinrichtung (1) zum Zuführen elektrischer Bauteile (5), welche in taschenartigen Vertiefungen (4) eines Bauteilgurts (2) gelagert und durch eine Abdeckfolie (6) abgedeckt sind, weist eine Abzugseinrichtung (9) zum Lösen der Abdeckfolie (6) von dem Bauteilgurt (2) auf, welche ein erstes Förderrad (13) mit einer ersten Umlauffläche (16) und ein zweites Förderrad (14) mit einer zweiten Umlauffläche (17) aufweist, wobei das erste Förderrad (13) und das zweite Förderrad (14) derart angeordnet sind, dass die Abdeckfolie (6) zwischen den Umlaufflächen (16, 17) durch Rotation der Förderräder (13, 14) transportierbar ist, und wobei zumindest die Umlauffläche (16, 17) eines der Förderräder (13, 14) in einer Umlaufrichtung glatt ausgeführt ist.

## Beschreibung

Die folgende Erfindung betrifft eine Zuführeinrichtung zum Zuführen elektrischer Bauteile, welche in taschenartigen Vertiefungen eines Bauteilgurtes gelagert und durch eine Abdeckfolie abgedeckt sind.

Aus der DE 4137193 ist eine Abzugseinrichtung für die Abdeckfolie von in Gurten verpackten Bauteilen offenbart, wobei die Abzugseinrichtung zwei ineinander greifende Zahnräder aufweist, zwischen denen die Abdeckfolie hindurchgeführt und durch Drehung der Zahnräder gefördert wird. Bei dieser Abzugseinrichtung kann es zu einer Beschädigung der Abdeckfolie und folglich zu Betriebsstörungen kommen.

Es ist deshalb die Aufgabe der vorliegenden Erfindung, eine Zuführeinrichtung zu liefern, welche sich durch eine höhere Betriebssicherheit ausweist.

Diese Aufgabe wird durch die Zuführeinrichtung gemäß dem unabhängigen Anspruch 1 gelöst. Vorteilhafte Ausgestaltungen der Erfindung sind Gegenstand der abhängigen Ansprüche.

Die Zuführeinrichtung gemäß Anspruch 1 eignet sich zum Zuführen elektrischer Bauteile, welche in taschenartigen Vertiefungen eines Bauteilgurtes gelagert sind. Um ein Herausfallen der Bauteile aus den Vertiefungen zu verhindern, sind diese durch eine Abdeckfolie abgedeckt. Die Zuführeinrichtung weist ferner eine Abzugseinrichtung zum Lösen der Abdeckfolie von dem Bauteilgurt auf. Die Abzugseinrichtung umfasst ein erstes Förderrad mit einer ersten Umlauffläche und ein zweites Förderrad mit einer zweiten Umlauffläche, welche derart angeordnet sind, dass die Abdeckfolie zwischen den Umlaufflächen der Förderräder durch Rotation der beiden Förderräder transportierbar ist. Erfindungsgemäß ist die Umlauffläche zumindest eines der Förderräder in einer Umlaufrichtung glatt ausgeführt. Dadurch wird die Gefahr einer Beschädigung der Abdeckfolie erheblich reduziert. Die Gefahr einer Zerfaserung der Abdeckfolie, wie es beim Transport der Abdeckfolie zwischen zwei ineinander greifenden Zahnrädern vorkommen kann, wird dadurch erheblich reduziert. Somit gelangen auch keine Fasern der Abdeckfolie in die Abzugseinrichtung, was schlimmstenfalls zu einer Blockierung der Abzugseinrichtung führen könnte. Dadurch wird die Betriebssicherheit der Zuführeinrichtung erheblich gesteigert.

Die Zuführeinrichtung kann gemäß Anspruch 2 auch dahingehend ausgestaltet werden, dass die Umlaufflächen beider Förderräder glatt ausgeführt sind. Bei Gewährleistung eines ausreichenden Anpressdruckes der beiden Umlaufflächen, welcher beispielsweise durch eine federnde Lagerung eines der beiden Förderräder realisiert werden kann, ist ein sicherer Transport der Abdeckfolie sichergestellt. Bei dieser Ausgestaltung ist eine Beschädigung der Abdeckfolie praktisch nicht mehr möglich.

Durch eine Ausgestaltung der Zuführeinrichtung nach Anspruch 3, derzufolge die Umlauffläche eines der beiden Förderräder gerändelt ausgeführt ist, kann die Griffigkeit der Umlaufflächen gegenüber der Abdeckfolie noch verbessert werden, ohne dabei die Gefahr einer Beschädigung der Abdeckfolie wesentlich zu erhöhen. Dies ergibt sich durch die grundlegend unterschiedliche Struktur einer Rändelung gegenüber einem Zahnrad.

Eine weitere Verbesserung der Transportsicherheit der Abdeckfolie bzw. der Griffigkeit der Umlaufflächen gegenüber der Abdeckfolie kann gemäß der Ausgestaltung nach Anspruch 4 auch durch eine Gummierung der Umlauffläche zumindest eines Förderrades erreicht werden. Gleichzeitig ergibt sich durch die Gummierung ein gewisser Dämpfungseffekt bei Erschütterung und zu hohen Anpresskräften zwischen den beiden Umlaufflächen, wodurch eine Beschädigung der Abdeckfolie weiter reduziert wird.

In einer Ausgestaltung nach Anspruch 5 weist die Zuführeinrichtung eine Antriebseinrichtung zum Transport des Bauteilgurtes, eine beweglich gelagerte Spanneinrichtung zum Spannen der abgelösten Abdeckfolie auf, wobei die Spanneinrichtung bei gespannter Abdeckfolie eine erste Lage und bei ungespannter Abdeckfolie eine zweite Lage einnimmt. Mittels einer Erfassungseinrichtung, welche mit der Antriebseinrichtung verbunden ist, kann die Lage der Spanneinrichtung erfasst werden. Die Antriebseinrichtung ist ferner derart ausgebildet, dass sie den Transport des Bauteilgurtes stoppt, falls die Erfassungseinrichtung feststellt, dass sich die Spanneinrichtung in der zweiten Lage befindet. Häufig werden die Abdeckfolien mittels der Abzugseinrichtung in einen Abfallbehälter gefördert. Um einen reibungslosen Fördervorgang zu gewährleisten, sind die Förderräder der Abzugseinrichtung meist unmittelbar an der Eingangsöffnung des Abfallbehälters angeordnet. Bei einer unbemerkten Überfüllung des Vorratsbehälters kann es vorkommen, dass sich die darin angesammelte Abdeckfolie gegen die beiden Förderräder stemmt und diese auseinanderdrückt. Dabei heben die Umlaufflächen der Förderräder von der Deckfolie ab, so dass die Abdeckfolie von der Spanneinrichtung zwischen den beiden Umlaufflächen der Förderräder entgegen deren Förderrichtung aus dem Abfallbehälter herausgezogen wird. In diesem Fall würde die Spanneinrichtung die zweite Lage einnehmen, was von der Erfassungseinrichtung sofort erkannt werden würde. Anschließend würde die Antriebseinrichtung den Transport des Bauteilgurtes stoppen, um größere Schäden innerhalb der Zuführeinrichtung zu verhindern. Ein Maschinenbediener würde auf das Anhalten des Antriebsmechanismus aufmerksam werden und könnte den Abfallbehälter für die Abdeckfolie entleeren. Größere Wartungsarbeiten, welche bei einem weiteren Betrieb der Zuführeinrichtung bei überfüllter Abdeckfolie notwendig wären, werden dadurch verhindert.

Im Folgenden wird ein Ausführungsbeispiel der vorliegenden Erfindung mit Bezug auf die beigefügten Figuren näher erläutert. In den Figuren sind:
Figur 1 eine schematische Darstellung eines Ausführungsbeispiels der vorliegenden Erfindung,
Figur 2 ein schematischer Längsschnitt eines Bauteilgurtes,
Figur 3 und Figur 4 jeweils eine vergrößerte Darstellung der Abzugseinrichtung der Zuführeinrichtung,
Figur 5 eine Darstellung eines Förderrades der Abzugseinrichtung.

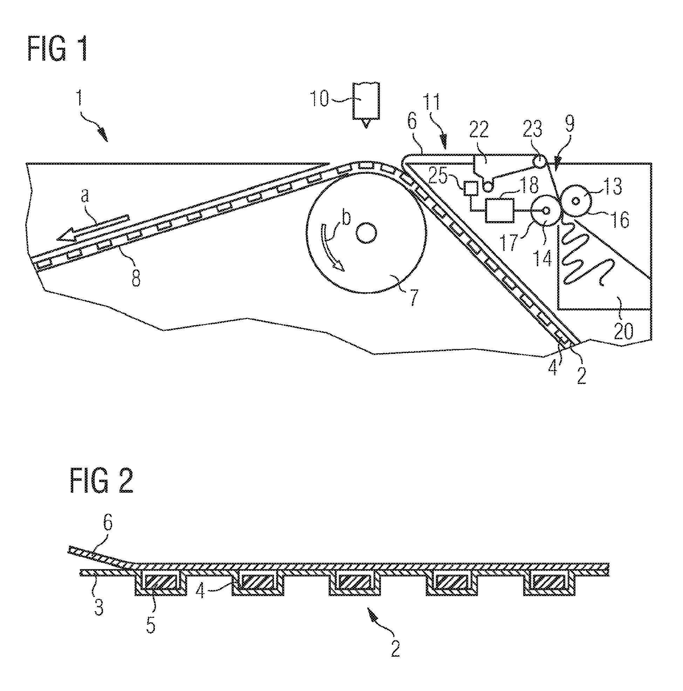

In Figur 1 ist ein Ausführungsbeispiel der erfindungsgemäßen Zuführeinrichtung 1 schematisch dargestellt. Aus Gründen der Übersicht sind nur die zur Erläuterung der Erfindung wesentlichen Bestandteile der Zuführeinrichtung 1 abgebildet. Auf die Darstellung untergeordneter Elemente der Zuführeinrichtung 1 wurde verzichtet. Die Zuführeinrichtung 1 eignet sich zum Transport von in einem Bauteilgurt gelagerten Bauteilen.

Wie in Figur 2 dargestellt ist, umfasst ein derartiger Bauteilgurt 2 einen Grundträger 3, welcher taschenartige Vertiefungen 4 aufweist. In diesen Vertiefungen 4 sind die Bauteile 5 gelagert. Um ein Herausfallen der Bauteile 5 zu verhindern, sind die Vertiefungen 4 mit einer auf den Grundträger 3 lösbar angebrachten Abdeckfolie 6 abgedeckt.

Wie aus Figur 1 hervorgeht, umfasst die Zuführeinrichtung 1 eine Antriebseinrichtung 7, mittels welcher der in einem Transportkanal 8 verlaufende Bauteilgurt 2 in einer Transportrichtung (Pfeil a) zu einer Abholposition der Zuführeinrichtung 1 transportiert werden kann. Bei der Antriebseinrichtung 7 kann es sich um ein Transportrad 7 mit radial abstehenden Transportstiften (nicht dargestellt) handeln, welche in entsprechende Transportperforationen (nicht dargestellt) am Bauteilgurt 2 eingreifen und diesen durch Drehung (Pfeil b) in der Transportrichtung transportieren. In Transportrichtung vor der Abholposition wird die Abdeckfolie 6 mittels einer Abzugseinrichtung 9 von dem Grundträger 3 des Bauteilgurtes 2 abgelöst. Die so freigelegten Bauteile 5 können dann an der Abholposition beispielsweise durch einen Bestückkopf 10 aus den Vertiefungen 4 entnommen werden.

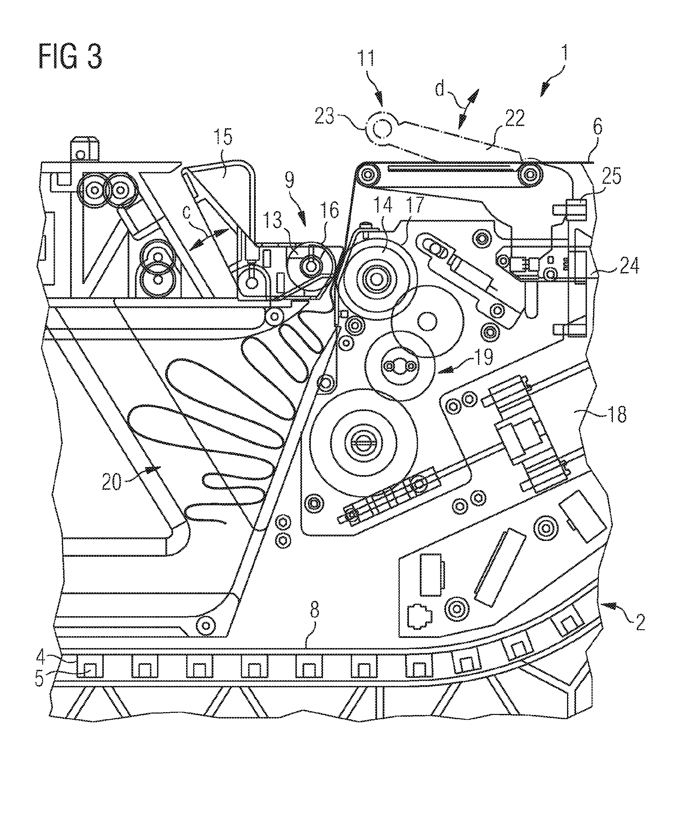

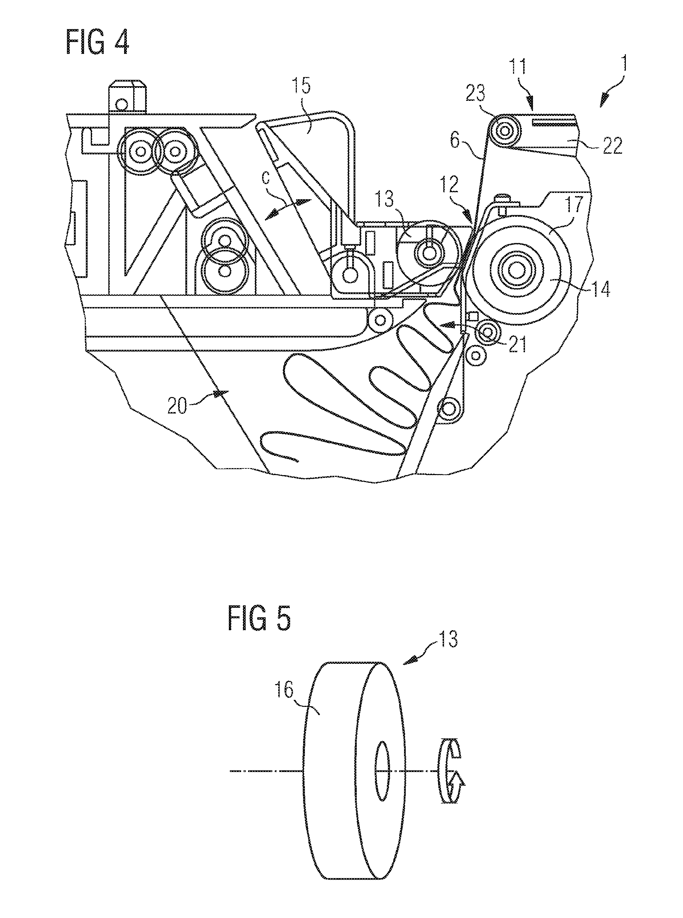

Die Figuren 3 und 4 zeigen jeweils einen Ausschnitt der erfindungsgemäßen Zuführeinrichtung 1, wobei die Abzugseinrichtung 9 vergrößert dargestellt ist. In Figur 3 ist ein Teil des Transportkanals 8 mit dem darin verlaufenden Bauteilgurt 2 zu erkennen. Die vom Grundträger 3 (siehe Figur 2) des Bauteilgurtes 2 abgezogene Abdeckfolie 6 wird über eine federnd gelagerte Spanneinrichtung 11 geführt, deren Funktion später näher erläutert wird. Die in einen Führungsschlitz 12 (siehe Figur 4) eingeführte Abdeckfolie 6 verläuft weiter zwischen einem ersten Förderrad 13 und einem zweiten Förderrad 14 der Abzugseinrichtung 9. Das in den Figuren 3 und 4 links befindliche, erste Förderrad 13 ist über einen Hebelmechanismus 15 beweglich (Pfeil c) und derart federnd gelagert, dass eine erste Umlauffläche 16 dieses ersten Förderrades 13 gegen eine zweite Umlauffläche 17 des ortsfest gelagerten, rechts befindlichen, zweiten Förderrades 14 mit einer definierten Anpresskraft gedrückt wird. Beide Förderräder 13, 14 sind gegenüber einem Gehäuse der Zuführeinrichtung 1 drehbar gelagert.

Wie aus Figur 3 hervorgeht, weist die Zuführeinrichtung 1 einen weiteren Antriebsmechanismus für das zweite Förderrad 14 auf. Das zweite Förderrad 14 wird dabei von einem Elektromotor 18 über ein Getriebe 19 in Drehung versetzt. Gleichzeitig wird dadurch auch das erste Förderrad 13 in Drehung versetzt. Die zwischen den Umfangsflächen 16, 17 des ersten und zweiten Förderrades 13, 14 verlaufende Abdeckfolie 6 wird bei Drehung der Förderräder 13, 14 in einen in der Zuführeinrichtung 1 integrierten Abfallbehälter 20 hineingefördert.

Wie aus Figur 4 deutlich wird, sind das erste und zweite Förderrad 13, 14 unmittelbar an einer Eingangsöffnung 21 des Abfallbehälters 20 angeordnet. Dabei ragt ein Teil der Umfangsfläche 13 des ersten Förderrades 13 in die Eingangsöffnung 21 (siehe Figur 4) des Abfallbehälters 20 hinein. Bei nicht rechtzeitiger Entleerung des Abfallbehälters 20 kann es daher vorkommen, dass sich die in den Abfallbehälter 20 gestopfte Folie bis zur Eingangsöffnung 21 des Abfallbehälters 20 aufstaut und in schleifenden Kontakt mit der ersten Umlauffläche 16 des ersten Förderrads 13 tritt. Bei Verwendung einer herkömmlichen Abzugseinrichtung 9, bei welcher beide Förderräder 13, 14 an ihren Umlaufflächen 16, 17 ineinander greifende Zahnräder aufweisen, kann es in dieser Situation dazu kommen, dass sich feine Fasern von der Abdeckfolie 6 lösen. Eine Zerfaserung der Abdeckfolie 6 kann auch durch die starke Quetschung der Abdeckfolie 6 zwischen den ineinander greifenden Zahnrädern hervorgerufen werden. Diese feinen Fasern können sich dann in die Lagerungen der Förderräder 13, 14 oder in andere Antriebsmechanismen der Zuführeinrichtungen verheddern. Im schlimmsten Fall kommt es zu einem vollständigen Stillstand der Zuführeinrichtung 1 und zeit- und kostenaufwändige Wartungsarbeiten sind die Folge.

Aus diesem Grund ist die Umfangsfläche von zumindest einem Förderrad 13, 14 in Umlaufrichtung glatt ausgebildet. Der Begriff "glatt" ist erfindungsgemäß so zu interpretieren, dass die Abdeckfolie 6 selbst bei andauernd schleifendem Kontakt mit der ersten Umlauffläche 16 des ersten Förderrads 13 nicht beschädigt wird. Im Ausführungsbeispiel ist dies die erste Umfangsfläche 16 des ersten Förderrades 13, da dieses teilweise in den Abfallbehälter hineinragt. In anderen Ausgestaltungen kann es jedoch notwendig sein, die Umfangsflächen 16, 17 beider Förderräder 13, 14 glatt zu gestalten. Die federnde Lagerung des ersten Förderrades 13, durch welche die erste Umfangsfläche 16 des ersten Förderrades 13 gegen die zweite Umfangsfläche 17 des zweiten Förderrades 14 gepresst wird, reicht aus, um die Abdeckfolie 6 sicher zu transportieren. Vorteilhafterweise kann jedoch die Umlauffläche des jeweils anderen Förderrads auch gerändelt ausgeführt werden. Dadurch wird die Griffigkeit erhöht, ohne die Gefahr einer Beschädigung der Abdeckfolie 6 nennenswert zu erhöhen. Eine weitere Verbesserung kann dadurch erreicht werden, indem die Umlauffläche eines oder beider Förderräder 13, 14 gummiert werden. Dies erhöht die Griffigkeit der Umlaufflächen gegenüber der Abdeckfolie 6 und es wird ein gewisser Dämpfungseffekt erreicht.

Ein Ausführungsbeispiel des ersten Förderrads 13 mit einer glatten Umlauffläche 16 ist beispielhaft in Figur 5 dargestellt. In diesem Ausführungsbeispiel ist das Förderrad 13 bzw. die Umlauffläche 16 in Umlaufrichtung völlig glatt, d.h. die Umlauffläche 16 weist in Umlaufrichtung keinerlei Erhebungen oder Kanten auf und das Förderrad 13 hat einen kreisförmigen Querschnitt. Der Erfindungsgedanke erstreckt sich jedoch auch auf Förderräder 13, deren Umlauffläche 16 Erhebungen, Rillen etc. aufweisen, welche derart geformt sind (beispielsweise abrundet), dass die Abdeckfolie 6 nicht beschädigt wird.

In den Figuren 3 und 4 ist auch noch die Spanneinrichtung 11 für die Abdeckfolie 6 vergrößert dargestellt. Dabei handelt es sich um einen Hebel 22, der an einem Ende drehbar (Pfeil d) gelagert ist. Am freien Ende des Hebels 22 ist eine Umlenkrolle 23 vorgesehen, über welche die Abdeckfolie 6 geführt wird. Der Hebel 22 ist an seinem drehbar gelagerten Ende mittels einer Feder 24 derart federnd gelagert, dass er in einem freien Zustand in eine erste Lage gezwängt wird, welche in Figur 3 gestrichelt dargestellt ist. Bei gespannter Abdeckfolie 6 bewirkt die Spannung der Abdeckfolie 6, dass der Hebel 22 entgegen der Federkraft wie eine zweite Lage gedrängt wird, welche in Figur 4 mittels durchgehender Linien dargestellt ist. Ein an der Zuführeinrichtung 1 vorgesehener Sensor 25, welcher mit dem Elektromotor gekoppelt ist (siehe Figur 1) und durch einen einfachen Schalter realisiert werden kann, erfasst die aktuelle Lage des Hebels 22. Nach längerem Betrieb der Zuführeinrichtung 1 kann es vorkommen, dass der Abfallbehälter 20 derart überfüllt ist, dass die darin enthaltene Abdeckfolie 6 das federnd gelagerte erste Förderrad 13 entgegen der Federkraft nach außen drängt, und so die erste Umfangsfläche 16 des ersten Förderrades 13 nicht mehr gegen die zweite Umfangsfläche 17 des zweiten Förderrades 14 gedrückt wird. In anderen Worten, in diesem Fall hebt die erste Umlauffläche 16 des ersten Förderrads 13 von der zweiten Umlauffläche 17 des zweiten Förderrades 14 ab. Durch den sich ergebenden Spalt wird die Abdeckfolie 6 von dem federnd vorgespannten Hebel 22 der Spanneinrichtung 11 aus dem Abfallbehälter 20 soweit herausgezogen, bis sich der Hebel 22 in der ersten Lage befindet, in welcher die Abdeckfolie 6 ungespannt ist. Dies wird von dem Sensor 25 erfasst, woraufhin der Antriebsmechanismus bzw. der Elektromotor 18 der Abzugseinrichtung 9 und zusätzlich eventuell die Antriebseinrichtung bzw. das Transportrad 7 der Zuführeinrichtung 1 unmittelbar gestoppt wird, um weiterem Schaden vorzubeugen.

## Patentansprüche

1. Zuführeinrichtung (1) zum Zuführen elektrischer Bauteile (5), welche in taschenartigen Vertiefungen (4) eines Bauteilgurts (2) gelagert und durch eine Abdeckfolie (6) abgedeckt sind, mit einer Abzugseinrichtung (9) zum Lösen der Abdeckfolie (6) von dem Bauteilgurt (2), welche ein erstes Förderrad (13) mit einer ersten Umlauffläche (16) und ein zweites Förderrad (14) mit einer zweiten Umlauffläche (17) aufweist, wobei das erste Förderrad (13) und das zweite Förderrad (14) derart angeordnet sind, dass die Abdeckfolie (6) zwischen den Umlaufflächen (16, 17) durch Rotation der Förderräder (13, 14) transportierbar ist, und
wobei zumindest die Umlauffläche (16, 17) eines der Förderräder (13, 14) in einer Umlaufrichtung glatt ausgeführt ist.

2. Zuführeinrichtung (1) nach Anspruch 1, wobei die Umlaufflächen (16, 17) beider Förderräder (13, 14) glatt ausgeführt sind.

3. Zuführeinrichtung (1) nach Anspruch 1, wobei die Umlauffläche (13, 14) eines der beiden Förderräder (16, 17) gerändelt ist.

4. Zuführeinrichtung (1) nach einem der Ansprüche 1 bis 3, wobei die Umlauffläche (16, 17) eines Förderrads (13, 14) eine Gummierung aufweist.

5. Zuführeinrichtung (1) nach einem der Ansprüche 1 bis 4, mit
- einer Antriebseinrichtung (7) zum Transport des Bauteilgurts (2)
- einer beweglich gelagerten Spanneinrichtung (11) zum Spannen der abgelösten Abdeckfolie (6), wobei die Spanneinrichtung (11) bei ungespannter Abdeckfolie (6) eine erste Lage und bei gespannter Abdeckfolie (6) eine zweite Lage einnimmt,
- einer Erfassungseinrichtung (25), welche mit der Antriebseinrichtung (7) verbunden ist und mit welcher die Lage der Spanneinrichtung (11) erfassbar ist,
wobei die Antriebseinrichtung (7) derart ausgebildet ist, dass sie den Transport des Bauteilgurts (2) stoppt, falls die Erfassungseinrichtung (25) erfasst, dass sich die Spanneinrichtung (11) in der ersten Lage befindet.
